# EUROPEAN PATENT APPLICATION

(11) **EP 3 054 491 A1**
(43) Date of publication of application: **10.08.2016**
(21) Application number: 16154061.2
(22) Date of filing: 03.02.2016
(51) Int. Cl.: H01L 33/50, H01L 33/54

(54) **LED PACKAGING STRUCTURE AND METHOD FOR MANUFACTURING THE SAME**

(30) Priority: 04.02.2015 US 201562112053 P
(71) Applicant: Everlight Electronics Co., Ltd, New Taipei City 23860 (TW)
(72) Inventor: Pan, Ke-Hao, 23860 New Taipei City (TW); Wu, Chi-Ming, 23860 New Taipei City (TW)
(74) Representative: Becker Kurig Straus

(57) **Abstract**

An LED package having a substrate, an LED chip, a phosphor sheet and a first resin is provided. The LED chip is disposed on the substrate. The phosphor sheet has a first area, and is affixed on a first surface of the LED chip. The first resin is disposed on the substrate for covering the LED chip along with the phosphor sheet, with at least a part of the phosphor sheet being exposed.

## Description

This application claims priority to US Provisional Application No. 62/112,053 filed on February 4, 2015.

### CROSS-REFERENCES TO RELATED APPLICATIONS

Not applicable.

### BACKGROUND OF THE INVENTION

### Field of the Invention

The present disclosure relates to light-emitting diode (LED) and, more particularly, to an LED package and a method for manufacturing the same.

### Descriptions of the Related Art

Conventionally, to make the light emitted from a LED package have an uniform light-emitting area, a wavelength converting layer (which is usually a resin containing phosphor) is disposed above the LED chip so that the light emitted from the LED chip excite the phosphor in the resin to produce white light, thereby providing desired light sources for users.

To achieve the aforesaid objectives of providing white light and providing a uniform light-emitting area, a known process of manufacturing a LED package includes affixing a phosphor sheet to a top surface of an LED chip, molding with a resin around the LED chip along with the phosphor sheet, and curing the resin so that the LED chip along with the affixed phosphor sheet is surrounded by the first resin with a portion of the phosphor sheet is exposed (i.e., not fully covered by the resin).

However, when affixing the phosphor sheet to the top surface of the LED chip in LED package, the top surface of the LED chip is firstly fully dispensed with adhesive. Such that when the phosphor sheet is placed on and affixed to the top surface of the chip, the adhesive between the top surface of the LED chip along with the phosphor sheet will be pressed and be squeezed out, and thus inevitably smears side surfaces of the chip and the subsequent molding space. This may cause problems such as non-uniform light emission, an opaque periphery of the chip and a thinner resin layer, which lead to lower reliability and yield of the LED package.

Accordingly, providing an LED package and a method for manufacturing the same, which can overcome the non-uniform light emission problem caused by spillover of the resin in the manufacturing process, provide a more uniform light-emitting area and meanwhile improving the reliability and the process yield, as well as provide an LED package which can achieve the same effect without using the phosphor sheet, is needed.

### SUMMARY OF THE INVENTION

The present disclosure describes various implementations of an LED package and fabrication methods thereof.

In one aspect, the light emitted from an LED chip of the LED package may excite a phosphor sheet or a phosphor resin to generate desired white light and provide a uniform light-emitting area.

In another aspect, a phosphor sheet is well adhesive to the LED chip without adhesive spillover, thereby avoiding the contamination problem in the manufacturing process.

Yet in one aspect, a molded phosphor resin instead of a phosphor sheet is used as the material of a wavelength converting layer in an LED packages.

In one aspect, an LED package may include: a substrate, an LED chip disposed on the substrate, a phosphor sheet, a first resin, and an adhesive, wherein the phosphor sheet is affixed to an upper surface of the LED chip via the adhesive.

In some implementations, the first resin may be deposited on the substrate such that the LED chip along with the affixed phosphor sheet is surrounded by the first resin with a portion of the phosphor sheet being exposed.

In some implementations, when affixing the phosphor sheet to the LED chip with the adhesive, the adhesive may not extend over the upper surface of the LED chip.

In one aspect, an LED may include a substrate, an LED chip disposed on the substrate, a phosphor resin disposed on the substrate to cover the LED chip, and a first resin disposed on the substrate to surround the phosphor resin with a part of the phosphor resin being exposed.

In some implementations, the first resin may not be in contact with the LED chip.

In another aspect, an LED package may include a substrate, an LED chip disposed on the substrate, a phosphor coating covering the LED chip, a transparent resin disposed on the substrate to cover the LED chip and the phosphor coating, and a first resin disposed on the substrate to surround the transparent resin with a part of the transparent resin being exposed In some implementations, the first resin may not be in contact with the LED chip.

In one aspect, a method of fabrication of an LED package may involve operations including the following: providing a substrate; bonding an LED chip onto the substrate; dispensing an adhesive to an upper surface of the LED chip to affix a phosphor sheet to the LED chip; and using a mold to apply pressure onto the phosphor sheet and filling a gap between the substrate and the mold with a first resin. When the mold applies the pressure to the phosphor sheet, the adhesive between the LED chip and the phosphor may not extend over the upper surface of the LED chip, and the first resin may cover the LED chip along with the phosphor sheet and may expose at least a part of the phosphor sheet.

In one aspect, a method of fabrication of an LED package may involve operations including the following: providing a substrate; bonding an LED chip onto the substrate; depositing a phosphor resin on the substrate to cover the LED chip; cutting the phosphor resin along the periphery of the LED chip; and further molding with a first resin on the substrate so that the first resin surrounds the periphery of the phosphor resin with at least a part of the phosphor resin being exposed and the first resin not being in contact with the LED chip.

In one aspect, a method of fabrication of an LED package may involve operations including the following: providing a substrate; bonding an LED chip and a Zener Diode chip adjacent to the LED chip onto the substrate; molding with a phosphor resin on the substrate to cover the LED chip and the Zener Diode chip; cutting the phosphor resin along the periphery of the LED chip and the periphery of the Zener Diode chip; and further molding with a first resin on the substrate so that the first resin surrounds the periphery of the phosphor resin with at least a part of the phosphor resin on the LED chip being exposed and the first resin being not in contact with the LED chip and the Zener Diode chip.

In one aspect, a method of fabrication of an LED package may involve operations including the following: providing a substrate; bonding an LED chip onto the substrate; spraying a phosphor coating on the LED chip; molding with a transparent resin on the substrate to cover the LED chip and the phosphor coating; cutting the transparent resin along the periphery of the LED chip; and further molding with a first resin on the substrate so that the first resin surrounds the periphery of the transparent resin with at least a part of the transparent resin being exposed and the first resin being not in contact with the LED chip.

In one aspect, a method of fabrication of an LED package may involve operations including the following: providing a substrate; bonding an LED chip and a Zener Diode chip adjacent to the LED chip onto the substrate; spraying a phosphor coating on the LED chip; molding with a transparent resin on the substrate to cover the LED chip and the Zener Diode chip; and cutting the transparent resin along the periphery of the LED chip and the periphery of the Zener Diode chip; and further molding with a first resin on the substrate so that the first resin surrounds the periphery of the transparent resin with at least a part of the transparent resin on the LED chip being exposed and the first resin being not in contact with the LED chip and the Zener Diode chip.

The foregoing summary is illustrative only and is not intended to be limiting in any way. That is, the foregoing summary is provided to introduce concepts, highlights, benefits and advantages of the novel and non-obvious techniques described herein. Select implementations are further described below in the detailed description. Thus, the foregoing summary is not intended to identify essential features of the claimed subject matter, nor is it intended for use in determining the scope of the claimed subject matter.

### BRIEF DESCRIPTION OF THE DRAWINGS

The accompanying drawings are included to provide a further understanding of the disclosure, and are incorporated in and constitute a part of the present disclosure. The drawings illustrate implementations of the disclosure and, together with the description, serve to explain the principles of the disclosure. It is appreciable that the drawings are not necessarily in scale as some components may be shown to be out of proportion than the size in actual implementation in order to clearly illustrate the concept of the present disclosure.
**FIG 1** shows a top view of an LED package in accordance with a first implementation of the present disclosure;
**FIG 2** shows a cross-sectional view of a first aspect of the LED package of **FIG 1**;
**FIG 2A** shows a partially schematic view of a phosphor sheet covering an LED chip in the LED package of **FIG 2**;
**FIG 2B** shows a partially schematic view of another aspect of the phosphor sheet covering the LED chip in the LED package of **FIG. 2**;
**FIG 3** shows a cross-sectional view of a second aspect of the LED package of **FIG 1**;
**FIG 4A** shows a top view of an LED package in accordance with a second implementation of the present disclosure;
**FIG 4B** shows a cross-sectional view of the LED package in accordance with the second implementation of the present disclosure;
**FIG. 5A** shows a top view of an LED package in accordance with a third implementation of the present disclosure;
**FIG 5B** shows a cross-sectional view of the LED package in accordance with the third implementation of the present disclosure;
**FIG 6** shows a top view of an LED package in accordance with a fourth implementation of the present disclosure;
**FIG 6A** shows a cross-sectional view of a first aspect of the LED package of **FIG 6**;
**FIG 6B** shows a cross-sectional view of a second aspect of the LED package of **FIG. 6**;
**FIG 6C** shows a cross-sectional view of a third aspect of the LED package of **FIG 6**;
**FIG 7A** shows a top view of an LED package in accordance with a fifth implementation of the present disclosure;
**FIG 7B** shows a cross-sectional view of the LED package in accordance with the fifth implementation of the present disclosure;
**FIG 8** shows a top view of an LED package in accordance with a sixth implementation of the present disclosure;
**FIG 8A** shows a cross-sectional view of a first aspect of the LED package of **FIG 8**;
**FIG 8B** shows a cross-sectional view of a second aspect of the LED package of **FIG. 8**;
**FIG 8C** shows a cross-sectional view of a third aspect of the LED package of **FIG 8**;
**FIG 9** shows a process of fabricating an LED package in accordance with a first implementation of the present disclosure;
**FIG 10** shows a process of fabricating an LED package in accordance with a second implementation of the present disclosure;
**FIG 11A** shows a process of fabricating an LED package in accordance with a third implementation of the present disclosure;
**FIG 11B** shows a process of fabricating an LED package in accordance with yet another implementation of the present disclosure;
**FIG 12** shows a process of fabricating an LED package in accordance with yet another implementation of the present disclosure;
**FIG 13** shows a process of fabricating an LED package in accordance with yet another implementation of the present disclosure; and
**FIG 14** shows a process of fabricating an LED package in accordance with yet another implementation of the present disclosure.

### DESCRIPTION OF THE PREFERRED EMBODIMENT

An LED package disclosed in the present disclosure uses an LED chip (e.g., a blue-light LED or an ultraviolet (UV) LED) to emit a light (e.g., blue light or ultraviolet light) so that the emitted light excites a phosphor sheet or a phosphor resin to generate white light and to further render an uniform light-emitting area.

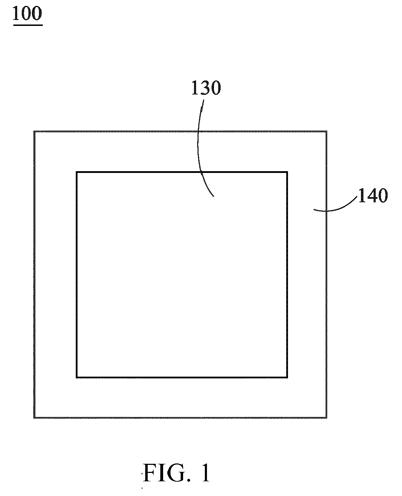

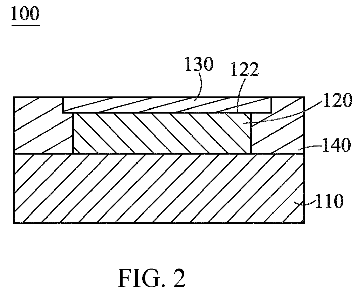

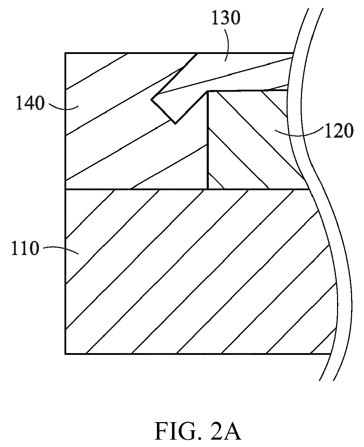

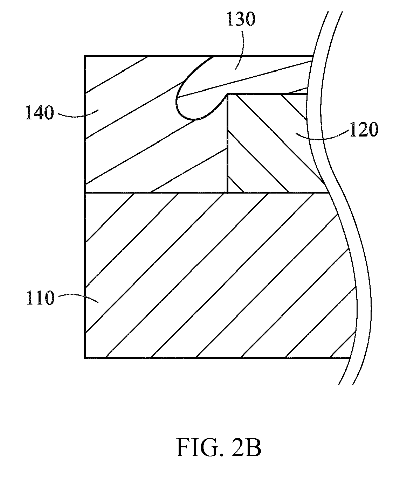

Firstly referring to **FIG 1** and **FIG 2**, which respectively shows a top view and a cross-sectional view of an LED package **100** in accordance with a first implementation of the present disclosure. As shown in **FIG 1** and **FIG 2**, the LED package **100** comprises a substrate 110, an LED chip 120, a phosphor sheet 130 and a first resin 140. The LED chip 120 is disposed on the substrate 110 and has an upper surface 122. The phosphor sheet 130 has a first area and through which the phosphor sheet 130 is affixed to the upper surface 122 of the LED chip 120. The first resin 140 is disposed on the substrate 110 and surround the LED chip 120 along with the phosphor sheet 130 with at least a part of the phosphor sheet being exposed.

In the present implementation, the applying area of the adhesive for affixing the phosphor sheet 130 to the LED chip 120 is smaller than or equal to an upper surface of the LED chip 120.

In the present implementation, the first area of the phosphor sheet 130 is slightly larger than the area of the upper surface **122** of the LED chip **120**. That is, the periphery of the phosphor sheet **130** extends beyond the upper surface **122** of the LED chip **120** to ensure that all lights emitted from the LED chip **120** emit through the phosphor sheet **130** and excite the phosphor particle contained within to generate white light.

It shall be appreciated that, the first resin **140** is made of an opaque material in accordance with the fist implementation of the present invention. Therefore, when the first resin **140** is disposed on the substrate **110** and surrounds the the LED chip **120** along with the periphery of the phosphor sheet **130** with at least one part of the phosphor sheet **130** being exposed, the white light is only emitted through the at least one exposed part of the phosphor sheet **130**.

Specifically, referring to **FIG 1** and **FIG 2**. In the LED package **100** in accordance with the first implementation, the substrate **110** is below the LED chip **120,** the phosphor sheet **130** is above the LED chip **120,** and the first resin **140** surrounds the periphery of the LED chip **120** and the periphery of the phosphor sheet **130.**

In other words, in the first implementation, the first resin **140** surrounding the periphery of the LED chip **120** and the periphery of the phosphor sheet **130** is not in contact with the upper surface **122** of the LED chip **120** that is used for emitting light. Thus, in the LED package **100** of the present implementation, the LED chip **120** is isolated from outside because it is covered by the substrate **110,** the phosphor sheet **130** and the first resin **140.** Moreover, the lights emitted from the LED chip **120** may only be emit through the phosphor sheet **130** and may be converted into the desired white light while phosphor particle contained in the phosphor sheet **130** is excited, and then the white light is emitted to outside.

Similarly, since the periphery of the phosphor sheet **130** is also covered by the opaque first resin **140**, the excited light may be intensively emitted towards the direction away from the phosphor sheet **130**.

It shall be particularly appreciated that, to achieve better bonding between the LED chip **120** and the phosphor sheet **130**, the first area of the phosphor sheet **130** may be slightly larger than the upper surface **122** of the LED chip **120** as shown in **FIG 2A**; and preferably, part of the first area of the phosphor sheet **130** that extends beyond the upper surface **122** of the LED chip **120** is inclined inwards towards the LED chip **120** to prevent the phosphor sheet **130** from being damaged or separated from the LED chip **120** due to thermal expansion and contraction or the contraction stress generated during the curing of the first resin **140** in the manufacturing process.

On the other hand, when the first area of the phosphor sheet **130** is slightly larger than the upper surface **122** of the LED chip **120,** part of the first area of the phosphor sheet **130** that extends beyond the upper surface **122** of the LED chip **120** may also be a curved surface that is concave downwards as shown in **FIG 2B****,** and this can also prevent the phosphor sheet **130** from being damaged or separated from the LED chip **120** due to thermal expansion and contraction or the contraction stress generated during the curing of the first resin **140** in the manufacturing process.

Moreover, such arrangement, by making the phosphor sheet **130** overly cover the LED chip **120,** can effectively ensure the lights of the LED chip **120** be emitted through the phosphor sheet **130** to generate desired white light no matter the lights are emitted from the upper surface **122** or from the side surfaces, thereby improving the illuminance and light uniformity of the LED package **100** of the present implementation.

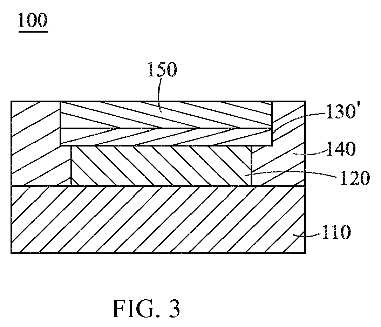

Next, referring to **FIG 3****,** which is a cross-sectional view of a second aspect of the LED package **100** according to the first implementation of the present disclosure. In the aspect shown in **FIG 3****,** the LED package **100** comprises a substrate **110,** an LED chip **120,** a translucent sheet **150** and a first resin **140.** The LED chip **120** is disposed on the substrate **110**, and the translucent sheet **150** is disposed on the substrate **110** and covers the LED chip **120**. The first resin **140** is disposed on the substrate **110** and is adapted to surround a periphery of the translucent sheet **150** and expose at least a part of the translucent sheet **150.** The translucent sheet **150** has at least one phosphor deposition sub-layer **130**', and the first resin **140** is not in contact with the LED chip **120.**

Specifically, as shown in **FIG. 3****,** the translucent sheet **150** is disposed on the upper surface of the LED chip **120.** Because the periphery of the translucent sheet **150** is covered by the opaque first resin **140,** the lights emitted from the LED chip **120** are emitted to the translucent sheet **150** and are converted to the desired white light after the phosphor deposition sub-layer **130'** in the translucent sheet **150** is excited, and then the white light is transmitted to the outside in a direction away from the phosphor sheet **120**.

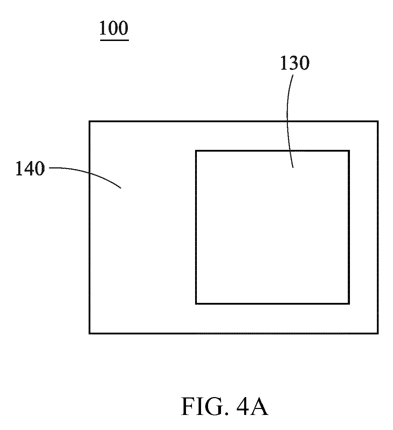

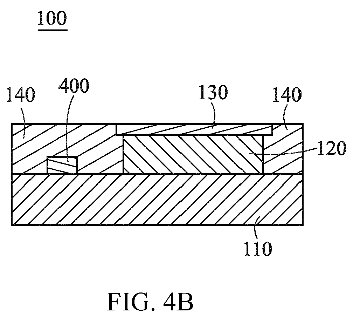

Next, please refer to **FIG 4A** and **FIG 4B****,** which are respectively a top view and a cross-sectional view of a second implementation of an LED package according to the present disclosure.

As shown in **FIG 4A** and **FIG 4B****,** the second implementation of the LED package **100** of the present disclosure, which is similar to the aforesaid first implementation of **FIG 1** and **FIG 2****,** may also comprise a substrate **110,** an LED chip **120,** a phosphor sheet **130** or a translucent sheet **150** having at least one phosphor deposition sub-layer **130',** and a first resin **140.**

The difference between the first implementation and the second implementation of the LED package **100** lies in that: the LED package **100** of the second implementation further comprises a Zener Diode chip **400** to additionally provide a voltage stabilizing function for the LED package **100.**

In detail, as shown in **FIG 4A** and **FIG 4B****,** the Zener Diode chip **400** is disposed on the substrate **110** and is parallel to the LED chip **120** in the second implementation. The Zener Diode chip **400** may be electrically connected with the substrate **110** through wire bonding, soldering, or eutectic or flip chip technology. Additionally, as shown in **FIG. 4B**, because the Zener Diode chip **400** is covered by the first resin **140**, the Zener Diode chip **400** is isolated from the outside after the first resin **140** is provided. Moreover, because the first resin **140** is made of an opaque material, the Zener Diode chip **400** cannot be seen from the top view of **FIG 4A**.

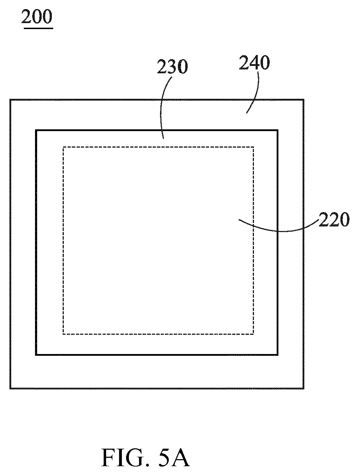

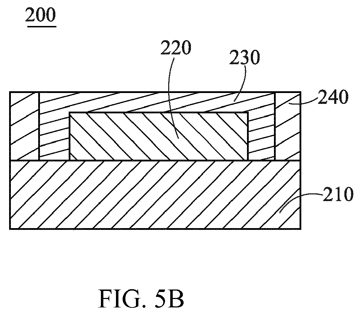

A top view and a cross-sectional view of a third implementation of an LED package according to the present disclosure are as shown in **FIG 5A** and **FIG 5B****.** As shown in **FIG 5A** and **FIG 5B****,** an LED package **200** of the third implementation comprises a substrate 210, an LED chip **220,** a phosphor resin **230** and a first resin **240.** The LED chip **220** is disposed on the substrate **210**, and the phosphor resin **230** is disposed on the substrate **210** and is adapted to cover the LED chip **220**. The first resin **240** is disposed on the substrate **210** and is adapted to surround a periphery of the phosphor resin **230** and expose at least a part of the phosphor resin **230** so that the first resin **240** is not in contact with the LED chip **220**.

In the present implementation, the phosphor resin **230** is a resin doped with a phosphor material or is directly made of a phosphor material. Because the phosphor resin **230** is disposed on the substrate **210** and covers the LED chip **220**, the LED chip **220** is isolated from the outside.

Furthermore, the first resin **240** is also made of an opaque material, and when the first resin **240** is disposed on the substrate **210** and is adapted to surround the periphery of the phosphor resin **230** and expose at least a part of the phosphor resin **230**, the first resin **240** is not in contact with the LED chip **220** because the LED chip **220** is isolated from the outside by the substrate **210** and the phosphor resin **230**.

In this way, because the LED chip **220** and the phosphor resin **230** are surrounded and covered by the opaque first resin **240**, the white light generated after the phosphor resin **230** is excited by the lights emitted from the LED chip **220** will be intensively emitted in the direction perpendicular to and away from the phosphor resin **230**.

It shall be appreciated that, in the third implementation, the phosphor resin **230** may have a rectangular cross section, a cross section that is narrower at the top but wider at the bottom or a trapezoid cross section to ensure centralization of the light-emitting surface and to improve the illuminance.

Thus, the LED package **200** of the third implementation has the following benefits: all the lights emitted from the LED chip **220** can be absorbed by the phosphor resin **230** to generate the desired white light; and a required height of the LED package **300** can be customized by directly changing the thickness of the phosphor resin **230** that is used, thereby simplifying the required processing procedures.

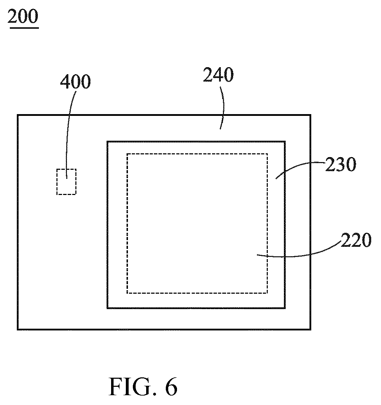

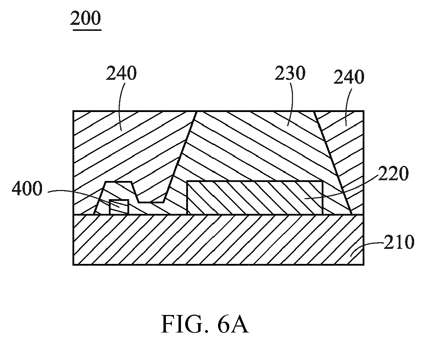

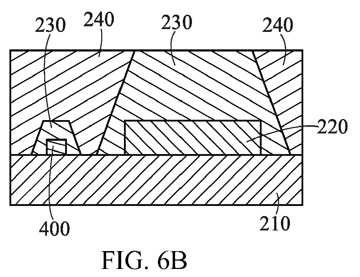

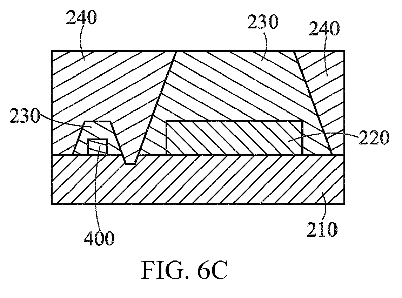

A top view and a cross-sectional view of a fourth implementation of an LED package according to the present disclosure are as shown in **FIG. 6** and **FIG 6A****.** The LED package **200** of the fourth implementation is similar to that of the third implementation and may also comprise a substrate **210,** an LED chip **220,** a phosphor resin **230** and a first resin **240**. The difference between the LED package **200** of the fourth implementation and that of the third implementation lies in that: the LED package **200** of the fourth implementation further comprises a Zener Diode chip **400.**

In detail, in a first aspect of the fourth implementation as shown in **FIG. 6A**, the Zener Diode chip **400** is disposed on the substrate **210** adjacent to the LED chip **220** and is covered by the phosphor resin **230.** Therefore, the Zener Diode chip **400** of the fourth implementation is also isolated from the outside because the Zener Diode chip **400** is also covered by the phosphor resin **230.**

It shall be particularly appreciated that, in the first aspect of the fourth implementation shown in **FIG 6A**, the phosphor resin **230** covering the Zener Diode chip **400** and the phosphor resin **230** covering the LED chip **220** communicate with each other. That is, the phosphor resin **230** disposed between the LED chip **220** and the Zener Diode chip **400** is continuous. In other words, in the cross-sectional view of **FIG 6A**, the phosphor resin **230** covers the substrate **210** between the LED chip **220** and the Zener Diode chip **400** so that the first resin **240** is not in contact with the substrate **210** between the LED chip **220** and the Zener Diode chip **400.**

A second aspect of the fourth implementation of the LED package according to the present disclosure is as shown in **FIG 6B****.** The difference between the second aspect and the aforesaid first aspect of the fourth implementation lies in that: the phosphor resin **230** covering the Zener Diode chip **400** and the phosphor resin **230** covering the LED chip **220** do not communicate with each other.

That is, as shown in a cross-sectional view of **FIG 6B****,** there is an gap between the phosphor resin **230** covering the LED chip **220** and the phosphor resin **230** covering the Zener Diode chip **400**. Thus, the first resin **240** can fill the gap and be in contact with the substrate **210** between the LED chip **220** and the Zener Diode chip **400**.

In this way, through the structural arrangement as shown in **FIG 6B**, the lights emitted from the LED chip **220** only propagate in the phosphor resin **230** surrounding the the LED chip **220** and cannot travel to the phosphor resin **230** surrounding the Zener Diode chip **400**. Thereby, light loss can be avoided to further improve the illuminance.

A third aspect of the fourth implementation of the LED package according to the present disclosure is as shown in **FIG 6C**. The difference between the third aspect and the first aspect of the fourth implementation lies in that: the phosphor resin **230** covering the Zener Diode chip **400** and the phosphor resin **230** covering the LED chip **220** do not communicate with each other, and moreover, a recessed portion **212** is further formed on the substrate **210** between the phosphor resin **230** covering the Zener Diode chip **400** and the phosphor resin **230** covering the LED chip **220**, and the bottom of the recessed portion **212** may be in a chamfered form to actually avoid light loss and further improve the illuminance.

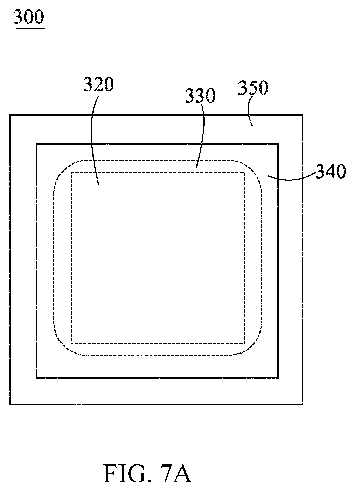

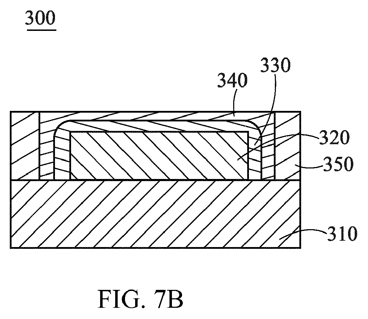

**FIG 7A** and **FIG 7B** are respectively a top view and a cross-sectional view of a fifth implementation of an LED package according to the present disclosure. As shown in **FIG. 7A** and **FIG 7B****,** an LED package **300** of the fifth implementation has a substrate **310,** an LED chip **320,** a phosphor coating **330,** a transparent resin **340** and a first resin **350.** The LED chip **320** is disposed on the substrate **310,** the phosphor coating **330** covers the LED chip **320,** and the transparent resin **340** is disposed on the substrate **310** and is adapted to cover the LED chip **320** and the phosphor coating **330**. The first resin **350** is disposed on the substrate **310** and is adapted to surround the periphery of the transparent resin **340** and expose at least a part of the transparent resin **340**, and the first resin **350** is not in contact with the LED chip **320**.

In detail, in the present implementation, the phosphor coating **330** is made of a highly volatile and transparent coating doped with a phosphor material or is directly made of a phosphor material, and the phosphor coating **330** is adapted to cover the surface of the LED chip **320.** That is, the phosphor coating **330** is in the form of a coating layer or a thin film, and it at least covers the upper surface of the LED chip **320.**

The transparent resin **340** is a resin of high transmittance and is disposed on the substrate **310** and adapted to cover the LED chip **320** and the phosphor coating **330.** Specifically, the transparent resin **340** covers the periphery and the upper surface of both the LED chip **320** and the phosphor coating **330** so that the LED chip **320** and the phosphor coating **330** are isolated from the outside. Thus, in the fifth implementation, the first resin **350** is not in contact with the LED chip **310**.

Moreover, the benefits of using the phosphor coating **330** and the transparent resin **340** are as follows: the possible damage to the phosphor sheet as in the prior art can be avoided by coating the phosphor coating **330** on the LED chip **320,** and a required height of the LED package **300** can be customized by controlling the thickness of the transparent resin **340.**

On the other hand, the transparent resin **340** may also have a rectangular cross section, a cross section that is narrower at the top but wider at the bottom or a trapezoid cross section to ensure centralization of the light-emitting surface and improve the illuminance.

It shall be appreciated that, when the phosphor coating **330** is coated on the LED chip **320** to cover the upper surface of the LED chip **320** in practice, the phosphor coating **330,** after being cured, is slightly collapsed to be attached on the surface of the LED chip **320** due to the action of gravity.

The difference between the LED package **300** of the fifth implementation and the LED package **100** of the first implementation lies in that: the LED package **300** of the fifth implementation uses the combination of the phosphor coating **330** and the transparent resin **340** instead of the phosphor sheet **130** comprised in the LED package **100** of the first implementation.

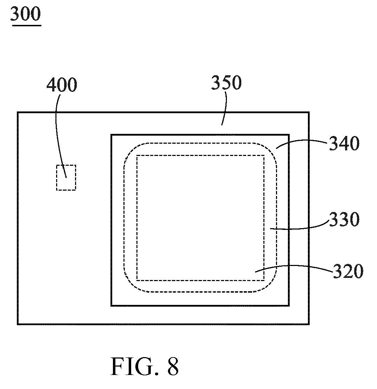

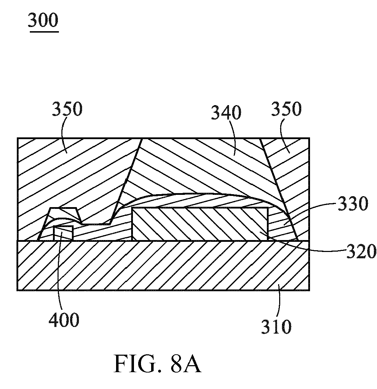

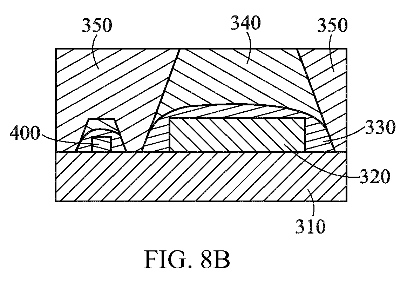

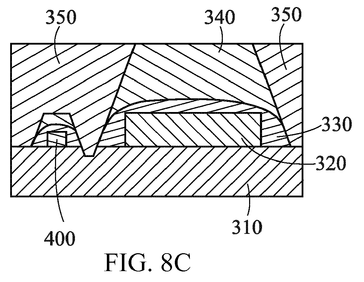

**FIG 8** and **FIG 8A** are respectively a top view and a cross-sectional view of a sixth implementation of an LED package according to the present disclosure. The LED package **300** of the sixth implementation is similar to that of the fifth implementation, and it may also comprise a substrate **310**, an LED chip **320**, a phosphor coating **330**, a transparent resin **340** and a first resin **350**. The difference between the LED package **300** of the sixth implementation and that of the fifth implementation lies in that: the LED package **300** of the sixth implementation may further comprise a Zener Diode chip **400.**

In detail, in a first aspect of the sixth implementation as shown in **FIG 8A****,** the Zener Diode chip **400** is disposed on the substrate **310**, and the Zener Diode chip **400** can also be covered by the transparent resin **340** because it is disposed adjacent to the LED chip **320**.

It shall be particularly appreciated that, in the first aspect of the sixth implementation shown in **FIG 8A****,** the transparent resin **340** covering the Zener Diode chip **400** and the transparent resin **340** covering the LED chip **320** link together. That is, the transparent resin **340** disposed between the LED chip **320** and the Zener Diode chip **400** is continuous. In other words, in the cross-sectional view of **FIG 8A****,** the transparent resin **340** covers the substrate **310** between the LED chip **320** and the Zener Diode chip **400** so that the first resin **350** is not in contact with the substrate **310** between the LED chip **320** and the Zener Diode chip **400**.

A second aspect of the sixth implementation of the LED package according to the present disclosure is as shown in **FIG 8B****.** The difference between the second aspect and the aforesaid first aspect of the sixth implementation lies in that: the transparent resin **340** covering the Zener Diode chip **400** and the transparent resin **340** covering the LED chip **320** do not link together.

That is, as shown in a cross-sectional view of **FIG 8B****,** there is a gap between the transparent resin **340** covering the LED chip **320** and the transparent resin **340** covering the Zener Diode chip **400.** Thus, the first resin **350** can fill the gap and be in contact with the substrate **310** between the LED chip **320** and the Zener Diode chip **400.**

In this way, through the structural arrangement as shown in **FIG 8B****,** the lights emitted from the LED chip **320** only propagate in the transparent resin **340** surrounding the LED chip **320** and cannot travel to the transparent resin **340** surrounding the Zener Diode chip **400.** Thereby, light loss can be avoided to further improve the illuminance.

A third aspect of the sixth implementation of the LED package according to the present disclosure is as shown in **FIG 8C**. The difference between the third aspect and the aforesaid first aspect of the sixth implementation lies in that: the transparent resin **340** covering the Zener Diode chip **400** and the transparent resin **340** covering the LED chip **320** do not link together, and moreover, a recessed portion **312** is further formed on the substrate **310** between the transparent resin **340** covering the Zener Diode chip **400** and the transparent resin **340** covering the LED chip **320,** and the bottom of the recessed portion **312** may be in a chamfered form to surely prevent the lights emitted by the LED chip **320** from traveling to the Zener Diode chip **400** to cause light loss and to further improve the illuminance.

The methods of fabrication an LED package and the operations involved will be described hereinafter.

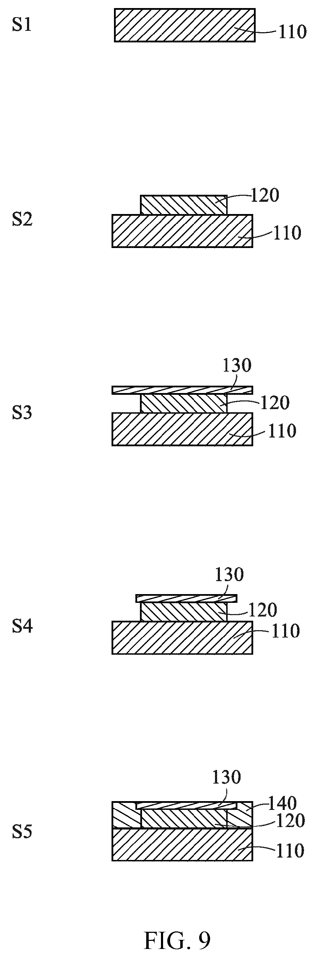

**FIG 9** shows a process of fabricating an LED package in accordance with a first implementation of the present disclosure. As shown in **FIG 9**, the method for manufacturing the LED package **100** may comprise the following steps.

First, in step **S1**, a substrate **110** is provided. Next, in step **S2**, an LED chip **120** is disposed on the substrate **110** through adhesive, soldering, or die bonding. In step **S3,** a phosphor sheet **130** is affixed to an upper surface **122** of the LED chip **120**. An area of the affixed phosphor sheet **130** is larger than an area of the upper surface **122** of the LED chip **120** (and is approximately equal to an area of the substrate **110**). Then, in step **S4**, the phosphor sheet **130** is cut so that the area of the phosphor sheet **130** finally is slightly larger than the area of the upper surface **122** of the LED chip **120**. Finally, in step **S5**, a first resin **140** is provided to cover the LED chip **120** along with the phosphor sheet **130** with at least a part of the phosphor sheet **130** being exposed. In this way, the LED package **100** as shown in **FIG. 2** can be correspondingly obtained.

It shall be appreciated that, after the step **S2,** a phosphor sheet **130** of which the area is slightly larger than the area of the upper surface **122** of the LED chip **120** can be directly affixed on the LED chip **120**, and thereby the step **S3** is omitted and the step **S4** is directly executed after the step **S2**.

Additionally in the step **S4**, when a pressure is applied to the phosphor sheet **130,** the phosphor sheet **130** may be disposed on the upper surface **122** of the LED chip **120** in such a way that the phosphor sheet **130** is inclined inwards towards the LED chip **120** (as shown in **FIG 2A**) or a curved surface that is concave downwards is formed by part of the phosphor sheet **130** that extends beyond the upper surface **122** of the LED chip **120** (as shown in **FIG 2B**) under the pressure. This prevents the phosphor sheet **130** from being damaged or separated from the LED chip **120** due to thermal expansion and contraction or the contraction stress generated during the curing of the first resin **140** in the subsequent manufacturing process. Meanwhile, this can ensure that the lights of the LED chip **120** can be emitted to the phosphor sheet **130** to generate the desired white light no matter the lights are emitted from the upper surface **122** or from the side surfaces of the LED chip **120**, thereby improving the illuminance and light uniformity of the LED package **100** of the present implementation.

Moreover, before the step **S5** is executed, a translucent sheet **150** may be disposed on the phosphor sheet **130**, and then a mold is used to apply a pressure to the translucent sheet **150**, and next the first resin **140** is provided to cover the aforesaid LED chip **120**, the phosphor sheet **130** and the translucent sheet **150** so that the LED package **100** can have the aforesaid structure as shown in **FIG 3**. In other words, through the arrangement of the translucent sheet **150**, the overall height of the LED package **100** can be adjusted depending on different customized requirements.

On the other hand, in the process of the step **S5**, a mold (not shown) may be used to apply a pressure to the phosphor sheet **130**, and a gap formed between the mold and the substrate **110**/the phosphor sheet **130** is filled with the first resin **140**. In this way, after the mold is removed, the LED package **100** of the first implementation in this application is formed. Moreover, because the first resin **140** only covers the upper surface of the substrate **110**, the periphery of the LED chip **120** and the periphery of the phosphor periphery **130,** the first resin **140** does not shield the upper surface of the phosphor sheet **130.**

In mass production of the LED package **100** as shown in **FIG 2****,** the steps of **FIG 9** may be adopted. First, a substrate **110** having a large area is provided, then a plurality of LED chips **120** are disposed on the substrate **110** in a matrix form, then a phosphor sheet **130** having an area approximately equal to the area of the substrate **110** is placed on the LED chips **120** and then cut into a plurality of small phosphor sheets **130,** the first resin **140** is provided so that the first resin **140** covers the LED chips **120** and the phosphor sheets **130,** and finally the overall structure is cut by a cutting tool into individual LED packages **100** as shown in **FIG 2**.

Similar steps may also be adopted for mass production of the LED package **100** as shown in **FIG 3****,** and the only difference is a further step of disposing the translucent sheet **150**, so this will not be further described herein.

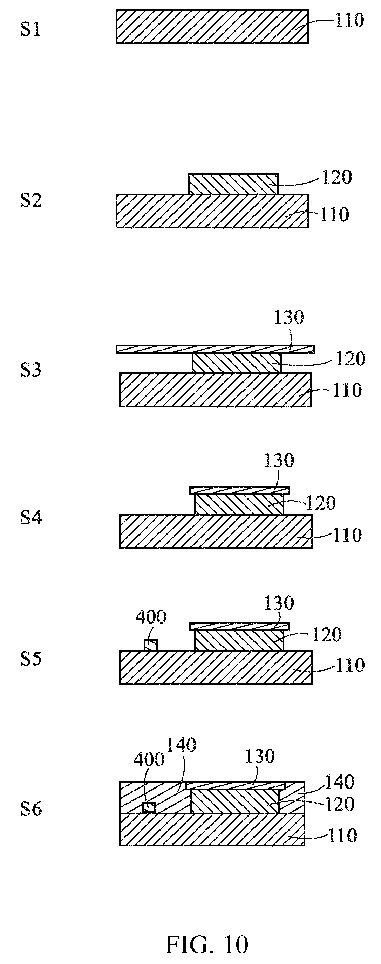

**FIG 10** shows a process of fabricating an LED package in accordance with a second implementation of the present disclosure. As shown in **FIG 10****,** the method for manufacturing the LED package **100** may comprise the following steps.

First, in step **S1**, a substrate **110** is provided. Next, in step **S2**, an LED chip **120** is disposed on the substrate **110** through adhesive, soldering, or die bonding. In step **S3**, a phosphor sheet **130** is affixed on an upper surface **122** of the LED chip **120**. An area of the affixed phosphor sheet **130** is larger than an area of the upper surface **122** of the LED chip **120** (and is approximately equal to an area of the substrate **110**). Then, in step **S4**, the phosphor sheet **130** is cut so that the area of the phosphor sheet **130** is slightly larger than the area of the upper surface **122** of the LED chip **120**. In step **S5**, a Zener Diode chip 400 is disposed on the substrate **110**. Finally, in step **S6**, a first resin **140** is provided to cover the LED chip **120**, the phosphor sheet **130** and the Zener Diode chip **400**, and to expose at least a part of the phosphor sheet **130**. In this way, the LED package **100** as shown in **FIG 4A** and **FIG 4B** can be correspondingly obtained.

In other words, the steps of **FIG 10** are generally the same as those of **FIG 9**, the only difference therebetween lies in that: the steps of **FIG 10** further include a step of disposing the Zener Diode chip **400** before providing the first resin **140**. In addition to the aforesaid difference, the steps of **FIG 10** are the same as those of **FIG 9**, and thus will not be further described herein.

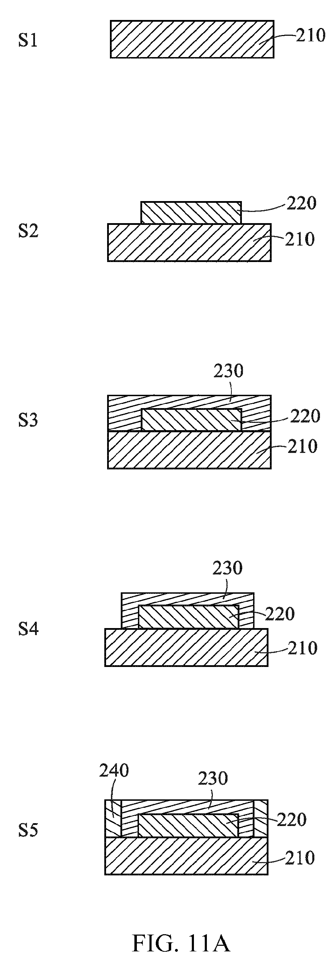

**FIG 11A** is shows a process of fabricating an LED package in accordance with a third implementation of the present disclosure. As shown in **FIG. 11A****,** the method for manufacturing the LED package **200** may comprise the following steps.

First, in step **S1**, a substrate **210** is provided. Next, in step **S2**, an LED chip **220** is disposed on the substrate **210**. In step **S3**, a phosphor resin **230** is molded on the substrate **210** to cover the LED chip **220**. In step **S4**, the phosphor resin **230** is cut along the periphery of the LED chip **220**. In step **S5***,* a first resin **240** is molded on the substrate **210** so that the first resin **240** covers the phosphor resin **230** and exposes at least a part of the phosphor resin **230,** and the first resin **240** is not in contact with the LED chip **220**.

In other words, after the step **S5** of **FIG. 11A** is finished, the LED package **200** as shown in **FIG 5A** and **FIG 5B** is obtained.

It shall be noted that, in the step **S4** of **FIG 11A****,** a cutting tool (not shown) is used to cut the phosphor resin **230** from top to bottom along the periphery of the LED chip **220**, so the phosphor resin **230** still has side walls perpendicular to the substrate **210** after being cut in an ideal status.

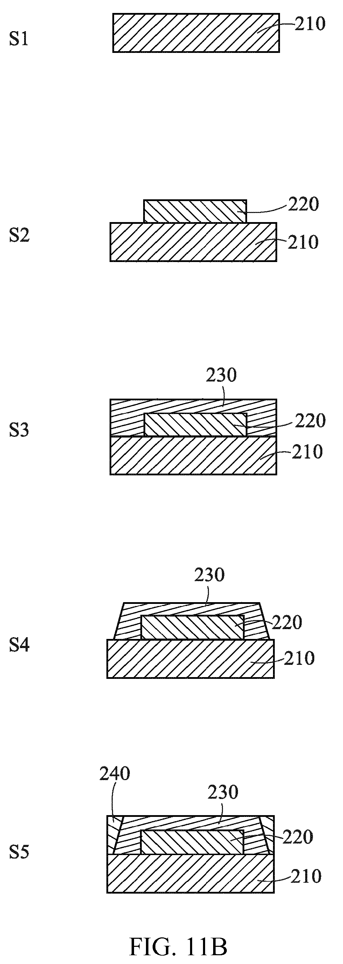

However, as shown in **FIG 11B****,** the cutting angle of the cutting tool may also be controlled so that the phosphor resin **230** surrounding the LED chip **220** has a cross section that is narrower at the top but wider at the bottom after being cut. This effectively controls the light path of the lights emitted from the LED chip **220** as they excite the phosphor resin **230,** thereby avoid light loss and further improve the illuminance.

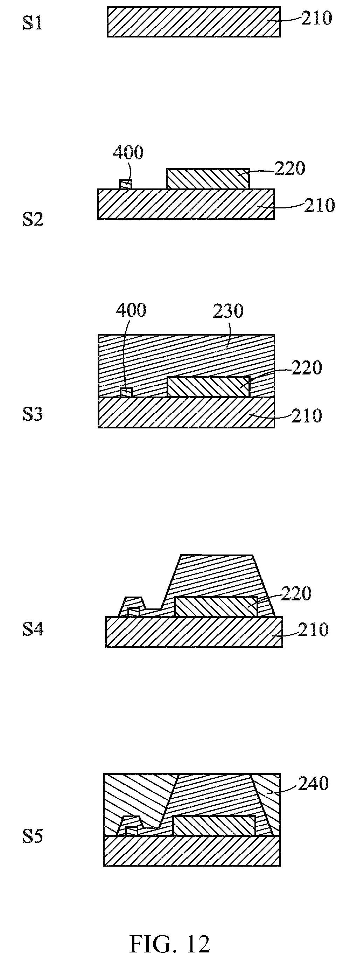

**FIG 12** shows a process of fabricating an LED package in accordance with a fourth implementation of the present disclosure. As shown in **FIG 12**, the method for manufacturing the LED package **200** may comprise the following steps.

First, as shown in step **S1**, a substrate **210** is provided. As shown in step **S2**, an LED chip **220** and a Zener Diode chip **400** adjacent to the LED chip **220** are disposed on the substrate **210**. As shown in step **S3**, a phosphor resin **230** is molded on the substrate **210** to cover the LED chip **220** and the Zener Diode chip **400**. As shown in step **S4**, the phosphor resin **230** is cut along the periphery of the LED chip **220** and the periphery of the Zener Diode chip **400**. Finally, as shown in step **S5**, a first resin **240** is molded on the substrate **210** so that the first resin **240** surrounds the periphery of the phosphor resin **240** and exposes at least a part of the phosphor resin **240** on the LED chip **220**, and the first resin **240** is not in contact with the LED chip **220** and the Zener Diode chip **400**.

It shall be appreciated that, in the step **S4** of **FIG 12**, when a cutting tool (not shown) is used to cut the phosphor resin **230** disposed between the LED chip **220** and the Zener Diode chip **400,** the cutting tool is not in contact with the substrate **210.** Therefore, similar to **FIG 6A** described above, the phosphor resin **230** disposed between the LED chip **220** and the Zener Diode chip **400** is continuous.

As shown in the step **S5** of **FIG 12****,** preferably, both the phosphor resin **230** covering the LED chip **220** and the phosphor resin **230** covering the Zener Diode chip **400** have a cross section that is narrower at the top but wider at the bottom in the present implementation, so white light generated after the lights emitted from the LED chip **220** excite the phosphor resin **230** will be intensively emitted from the LED package **200.**

Additionally, when the cutting tool is controlled to cut the phosphor resin **230** in the step **S5** of **FIG 12**, the cutting tool may also cut until it is in contact with the substrate **210** or even cut into the substrate **210.** Thus, the first resin **240** provided later can fill the space between the LED chip **220** and the Zener Diode chip **400** and make contact with the substrate **210** between the LED chip **220** and the Zener Diode chip **400,** thereby presenting an LED package in the aforesaid form shown in **FIG 6B** and **FIG 6C****.**

In this way, when the LED package **200** is in the form shown in **FIG 6B** and **FIG 6C****,** the lights emitted from the LED chip **220** only propagate in the phosphor resin **230** surrounding the LED chip **220** and cannot travel to the phosphor resin **230** surrounding the Zener Diode chip **400**. In other words, with such arrangement, light loss can be avoided to further improve the illuminance.

The aforesaid step **S4** of cutting the phosphor resin **230** with a cutting tool may further be done by cutting the phosphor resin **230** in one time and cutting the phosphor resin **230** in several times. That is, if the cutting tool used is wide, then the unnecessary phosphor resin **230** can be cut and removed in one time. If the cutting tool used is narrow, then the unnecessary phosphor resin **230** can be cut and removed in several times.

It shall be noted that, even if the surface of the phosphor resin **230** above the Zener Diode chip **400** becomes serrated or wavy instead of being a flat surface shown in the step **S4** in **FIG 12** when the phosphor resin **230** is cut and removed in several times, it still falls within the scope of the technical features claimed in this application.

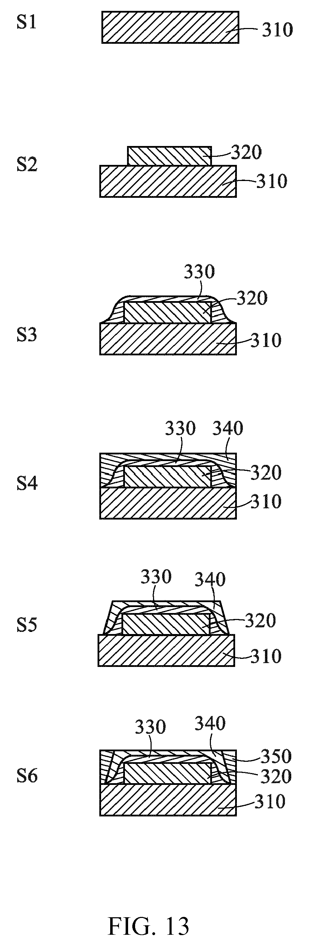

**FIG 13** is a schematic view of a method and steps thereof for manufacturing the fifth implementation of the LED package according to the present disclosure. As shown in **FIG 13**, the method for manufacturing the LED package **300** may comprise the following steps.

First, as shown in step **S1**, a substrate **310** is provided. As shown in step **S2,** an LED chip **320** is disposed on the substrate **310.** As shown in step **S3,** a phosphor coating **330** is coated on the LED chip **320.** As shown in step **S4**, a transparent resin **340** is molded on the substrate **310** to cover the LED chip **320** and the phosphor coating **330**. As shown in step **S5,** the transparent resin **340** is cut along the periphery of the LED chip **320**. Finally, as shown in step **S6**, a first resin **350** is molded on the substrate **310** so that the first resin **350** surrounds the periphery of the transparent resin **340** and exposes at least a part of the transparent resin **340**, and the first resin **350** is not in contact with the LED chip **320**.

Therefore, similar to the description of the fifth implementation shown in **FIG 7A** and **FIG 7B**, the transparent resin **340** is a resin of high transmittance, so the LED chip **320** and the phosphor coating **330** are all isolated from outside and the first resin **350** is not in contact with the LED chip **310** when the transparent resin **340** is disposed on the substrate **310** and covers the LED chip **320** and the phosphor coating **330**. Moreover, a required height of the LED package **300** can also be customized by directly changing the thickness of the transparent resin **340**.

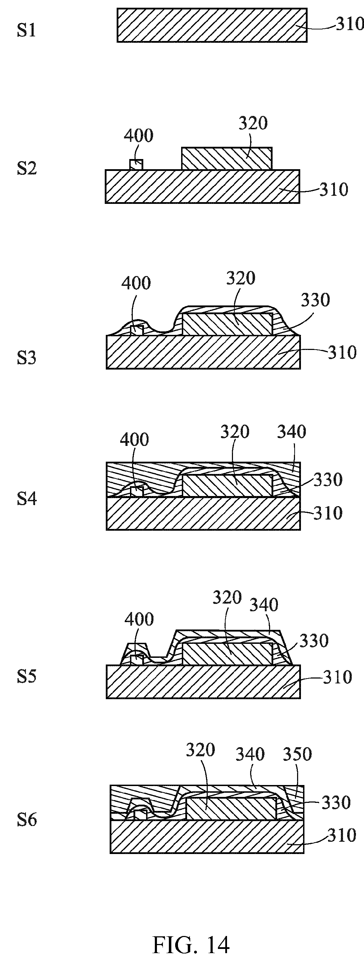

**FIG 14** is a schematic view of a method and steps thereof for manufacturing the sixth implementation of the LED package according to the present disclosure. As shown in **FIG 14**, the method for manufacturing the LED package **300** may comprise the following steps.

First, as shown in step **S1**, a substrate **310** is provided. As shown in step **S2**, an LED chip **320** and a Zener Diode chip **400** adjacent to the LED chip **320** are disposed on the substrate **310**. As shown in step **S3**, a phosphor coating **330** is coated on the LED chip **320**. As shown in step **S4**, a transparent resin **340** is molded on the substrate **310** to cover the LED chip **320** and the Zener Diode chip **400**. As shown in step **S5**, the transparent resin **340** is cut along the periphery of the LED chip **310** and the periphery of the Zener Diode chip **400**. Finally, as shown in step **S6**, a first resin **350** is molded on the substrate **310** so that the first resin **350** surrounds the periphery of the transparent resin **340** and exposes at least a part of the transparent resin **340** on the LED chip **320**, and the first resin **350** is not in contact with the LED chip **320** and the Zener Diode chip **400**.

Therefore, similar to the description of the sixth implementation shown in **FIG 8** and **FIG 8A****,** the transparent resin **340** is a resin of high transmittance, so the LED chip **320**, the Zener Diode chip **400** and the phosphor coating **330** are all isolated from the outside and the first resin **350** is not in contact with the LED chip **310** and the Zener Diode chip **400** when the transparent resin **340** is disposed on the substrate **310** and covers the LED chip **320**, the Zener Diode chip **400** and the phosphor coating **330**. Meanwhile, a required height of the LED package **300** can also be customized by directly changing the thickness of the transparent resin **340**.

Additionally, similar to **FIG 12**, when the cutting tool is controlled to cut the transparent resin **340** in the step **S5** of **FIG 13**, the cutting tool may also cut until it is in contact with the substrate **310** or even cut into the substrate **310**. Thus, the first resin **350** provided later can fill the space between the LED chip **320** and the Zener Diode chip **400** and be in contact with the substrate **310** between the LED chip **320** and the Zener Diode chip **400**, thereby presenting an LED package in the aforesaid form shown in **FIG 8B** and **FIG 8C**.

In this way, when the LED package is in the form as shown in **FIG 8B** and **FIG. 8C**, the lights emitted from the LED chip **320** only propagate in the transparent resin **340** surrounding the LED chip **320** and cannot travel to the transparent resin **340** surrounding the Zener Diode chip **400**. In other words, with such arrangement, light loss can be avoided to further improve the illuminance.

According to the above descriptions, all the LED packages disclosed in the implementations of the present disclosure can be produced by machines required in the current processes. Meanwhile, the LED packages can also provide a more uniform light-emitting area, prevent the phosphor sheet from being damaged or separated from the LED chip, improve the reliability of products and provide better protection for the LED chip and the Zener Diode chip.

### ADDITIONAL NOTES

Implementations of the present disclosure are not limited to those described herein. The actual design and implementation of each component of the LED package in accordance with the present disclosure may vary from the implementations described herein. Those ordinarily skilled in the art may make various deviations and improvements based on the disclosed implementations, and such deviations and improvements are still within the scope of the present disclosure. Accordingly, the scope of protection of a patent issued from the present disclosure is determined by the claims as follows.

In the above description of exemplary implementations, for purposes of explanation, specific numbers, materials configurations, and other details are set forth in order to better explain the present disclosure, as claimed. However, it will be apparent to one skilled in the art that the claimed subject matter may be practiced using different details than the exemplary ones described herein. In other instances, well-known features are omitted or simplified to clarify the description of the exemplary implementations.

Moreover, the word "exemplary" is used herein to mean serving as an example, instance, or illustration. Any aspect or design described herein as "exemplary" is not necessarily to be construed as preferred or advantageous over other aspects or designs. Rather, use of the word exemplary is intended to present concepts and techniques in a concrete fashion. The term "techniques," for instance, may refer to one or more devices, apparatuses, systems, methods, articles of manufacture, and/or computer-readable instructions as indicated by the context described herein.

As used in this application, the term "or" is intended to mean an inclusive "or" rather than an exclusive "or." That is, unless specified otherwise or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more," unless specified otherwise or clear from context to be directed to a singular form.

For the purposes of this disclosure and the claims that follow, the terms "coupled" and "connected" may have been used to describe how various elements interface. Such described interfacing of various elements may be either direct or indirect.

## Claims

1. A light emitting diode (LED) package, comprising:
a substrate;
an LED chip being disposed on the substrate;
an adhesive;
a phosphor sheet having a first area, being affixed on an upper surface of the LED chip via the adhesive; and
a first resin being disposed on the substrate and adapted to surround a periphery of the LED chip and a periphery of the phosphor sheet and expose at least a part of the phosphor sheet;
wherein a diffusion area of the adhesive is not larger than an area of the upper surface of the LED chip when the phosphor sheet is affixed on the LED chip via the adhesive.

2. The LED package of Claim 1, wherein the first area of the phosphor sheet is slightly larger than the upper surface of the LED chip.

3. The LED package of Claim 2, wherein part of the first area of the phosphor sheet that extends beyond the upper surface of the LED chip is inclined inwards towards the LED chip.

4. The LED package of Claim 2, wherein part of the first area of the phosphor sheet that extends beyond the upper surface of the LED chip is a curved surface that is concave downward.

5. The LED package of Claim 1, further comprising a Zener Diode chip disposed on the substrate and covered by the first resin.

6. The LED package of Claim 1, wherein the phosphor sheet comprises at least one phosphor deposition sub-layer.

7. An LED package, comprising:
a substrate;
an LED chip being disposed on the substrate;
a phosphor resin being disposed on the substrate to cover the LED chip; and
a first resin being disposed on the substrate to surround a periphery of the phosphor resin and expose at least a part of the phosphor resin, wherein the first resin is not in contact with the LED chip.

8. The LED package of Claim 7, wherein the phosphor resin has a cross section that is narrower at the top but wider at the bottom.

9. The LED package of Claim 7, further comprising a Zener Diode chip disposed on the substrate adjacent to the LED chip and covered by the phosphor resin.

10. The LED package of Claim 9, wherein the phosphor resin covering the Zener Diode chip and the phosphor resin covering the LED chip link to each other.

11. The LED package of Claim 9, wherein the phosphor resin covering the Zener Diode chip and the phosphor resin covering the LED chip do not link to each other.

12. The LED package of Claim 9, wherein a recessed portion is formed on the substrate between the phosphor resin covering the Zener Diode chip and the phosphor resin covering the LED chip.

13. The LED package of Claim 12, wherein the bottom of the recessed portion is in a chamfered form.

14. An LED package, comprising:
a substrate;
an LED chip being disposed on the substrate;
a phosphor coating being coated on a surface of the LED chip;
a transparent resin being disposed on the substrate to cover the LED chip and the phosphor coating; and
a first resin being disposed on the substrate to surround a periphery of the transparent resin and expose at least a part of the transparent resin, wherein the first resin is not in contact with the LED chip.

15. The LED package of Claim 14, wherein the transparent resin has a cross section that is narrower at the top but wider at the bottom.

16. The LED package of Claim 14, further comprising a Zener Diode chip disposed on the substrate adjacent to the LED chip and covered by the transparent resin.

17. The LED package of Claim 16, wherein the transparent resin covering the Zener Diode chip and the transparent resin covering the LED chip link to each other.

18. The LED package of Claim 16, wherein the transparent resin covering the Zener Diode chip and the transparent resin covering the LED chip do not link to each other.

19. The LED package of Claim 16, wherein a recessed portion is formed on the substrate between the transparent resin covering the Zener Diode chip and the transparent resin covering the LED chip.

20. The LED package of Claim 19, wherein the bottom of the recessed portion is in a chamfered form.
